# EUROPEAN PATENT SPECIFICATION

(11) **EP 4 535 436 B1**
(45) Date of publication and mention of the grant of the patent: **29.04.2026**
(21) Application number: 23838641.1
(22) Date of filing: 16.06.2023
(51) Int. Cl.: H10F 71/00

(54) **PREPARATION METHOD FOR BORON-DOPED EMITTER**
HERSTELLUNGSVERFAHREN FÜR BORDOTIERTEN EMITTER
PROCÉDÉ DE PRÉPARATION D'ÉMETTEUR DOPÉ AU BORE

(30) Priority: 14.07.2022 CN 202210824735
(43) Date of publication of application: 09.04.2025
(73) Proprietor: Jolywood (Taizhou) Solar Technology Co., Ltd., Taizhou, Jiangsu 225500 (CN)
(72) Inventor: LIN, Jianwei, Taizhou, Jiangsu 225500 (CN)
(74) Representative: Yang, Shu
(86) International application number: PCT/CN2023/100567
(87) International publication number: WO 2024/012147

(56) References cited:
- CN-A- 110 571 149
- CN-A- 112 164 728
- CN-A- 114 023 635
- CN-A- 114 551 639
- CN-A- 115 036 396
- CN-B- 109 545 673
- US-A1- 2020 279 970
- US-A1- 2022 140 178

## Description

### TECHNICAL FIELD

The present invention relates to the technical field of photovoltaic cells, and in particular to a preparation method for boron-doped emitter.

### BACKGROUND OF THE PRESENT INVENTION

A traditional preparation method for boron-doped emitter (i.e., traditional preparation method) is tubular boron diffusion: i.e., in a tubular furnace, nitrogen is introduced as an atmosphere in the tube, boron trichloride or boron tribromide is introduced as a doping source, and boron is diffused into a silicon wafer through high-temperature diffusion to form boron-doped emitter. In the boron diffusion process, a borosilicate glass layer (the main components of borosilicate glass layer include silicon dioxide, and the borosilicate glass layer needs to be removed in the cell manufacturing process) is generated on the silicon wafer (the silicon wafer is generally a monocrystalline silicon wafer or polycrystalline silicon wafer). However, since the solid solubility of boron in silicon dioxide is higher than that of boron in silicon, the interfacial segregation coefficient will be different between the silicon wafer and silicon dioxide in the boron diffusion process. As a result, more boron atoms will enter silicon dioxide. After the boron-doped emitter is obtained, the boron doping concentration in the silicon dioxide will be higher than that in the silicon wafer, and the boron doping concentration in the silicon wafer will gradually increase and then gradually decrease from the surface layer of the silicon wafer (i.e., the surface layer of the boron-doped emitter) to the bulk of the silicon wafer (i.e., the inside of the silicon wafer). Thus, the boron-doped ECV (electrochemical differential capacitance voltage) curve of the boron-doped emitter obtained by the traditional preparation method is an arched parabola, and this boron-doped ECV curve determines that the maximum value of the boron doping concentration is not at the surface layer of the silicon wafer but in a certain depth (>150 nm) inside the silicon wafer after preparation of the boron-doped emitter. Since the boron doping concentration of the bulk of the silicon wafer is higher than that at the surface layer of the silicon wafer, higher SRH recombination and auger recombination of the bulk of the silicon wafer will be caused. Moreover, the subsequent electrode metal slurry also needs to be sintered to a larger depth to realize better contact with the boron-doped emitter. However, if the sintered depth is larger, the electrode metal slurry will cause greater corrosion damage to the emitter region, and the heavy metal elements in the electrode metal slurry will also be distributed deeper in the silicon wafer, resulting in greater damage to the space charge region, thereby causing surface recombination of the boron-doped emitter and matching difficulty of the electrode metal slurry.

In the existing preparation methods for boron-doped emitter, as disclosed in CN114023635A, CN109545673B and US2022/140178A1, boron-doped amorphous silicon is first deposited and then annealed and diffused. The boron-doped amorphous silicon (which will be crystallized into boron-doped polycrystalline silicon at a high temperature in the annealing process) is used as the doping source for the boron-doped emitter to avoid the generation of the intermediate B₂O₃, thereby reducing the content of inactive boron. Accordingly, better boron doping uniformity can be achieved, and at the same time, the corrosion damage to quartz parts by B₂O₃ can be avoided. Although this existing preparation method can improve the boron doping uniformity of the boron-doped emitter and thus reduce recombination, in the boron-doped ECV curve of the boron-doped emitter obtained by this preparation method, the maximum value of the boron doping concentration is not at the surface layer of the silicon wafer. As a result, by improving the boron doping uniformity to reduce recombination, the recombination improvement effect is limited, and the silicon wafer with the prepared boron-doped emitter still has high surface recombination and bulk recombination.

### SUMMARY OF THE PRESENT INVENTION

The objective of the present invention is to overcome the deficiencies in the prior art and provide a preparation method for a boron-doped emitter, to achieve a boron-doped ECV curve distinct from that of boron-doped emitter prepared by a traditional preparation method, thereby achieving lower surface recombination and improved contact with an interfacial metal electrode, and leading to reduced bulk recombination.

On this basis, the present invention discloses a preparation method for boron-doped emitter, including the following steps:
S1: cleaning and texturing an n-type silicon wafer to remove damaged layers on surfaces of the silicon wafer and form pyramid-shaped textured surfaces on the front and back surfaces of the silicon wafer;
S2: preparing a boron-doped amorphous silicon layer on the textured surface of the front surface of the silicon wafer;
S3: carrying out annealing treatment to the boron-doped amorphous silicon layer, diffusing boron atoms of the boron-doped amorphous silicon layer inward to the silicon wafer to form boron-doped emitter on the front surface of the silicon wafer, the amorphous silicon layer is crystallized and transformed into a polycrystalline silicon layer on the front surface of the boron-doped emitter, and introducing oxygen in the cooling process, so that a borosilicate glass layer is formed on the front surface of the polycrystalline silicon layer, and a silicon dioxide layer is formed on the back surface of the silicon wafer;
S4: removing the silicon dioxide layer, and polishing the back surface of the silicon wafer to form flat morphological appearance on the back surface of the silicon wafer; and
S5: removing the borosilicate glass layer and the polycrystalline silicon layer in sequence, so that the boron-doped emitter is exposed and located on the front surface of the silicon wafer, the boron doping concentration of the front surface of the boron-doped emitter being not less than 95% of the maximum value of the boron doping concentration of the boron-doped emitter.

Preferably, in the step S5, the maximum value of the boron doping concentration is at a surface layer of the silicon wafer within a depth of 50 nm from the front surface of the boron-doped emitter.

Preferably, in the step S3, the annealing treatment process is: sequentially forming the boron-doped emitter and the polycrystalline silicon layer on the front surface of the silicon wafer at high temperature of 900°C to 1050°C, then cooling, and introducing oxygen in the cooling process, so that the borosilicate glass layer with a thickness of 40 to 60 nm is formed on the front surface of the polycrystalline silicon layer.

Further preferably, in the step S4, single-sided HF cleaning is carried out on the back surface of the silicon wafer to remove the silicon dioxide layer and reserve the borosilicate glass layer on the front surface of the silicon wafer, and the back surface of the silicon wafer is polished with an alkali solution to form flat morphological appearance on the back surface of the silicon wafer.

Preferably, the step S2 is: preparing an in-situ boron-doped amorphous silicon layer on the textured surface of the front surface of the silicon wafer.

Preferably, the step S2 is: preparing an intrinsic amorphous silicon layer on the textured surface of the front surface of the silicon wafer, and performing ion implantation or boron diffusion doping treatment on the intrinsic amorphous silicon layer to obtain a boron-doped amorphous silicon layer.

Further preferably, when performing the ion implantation treatment to the intrinsic amorphous silicon layer, BF₂ is used as a doping source for the boron-doped amorphous silicon layer, and the doping dose of BF₂ is 1-10E15.cm⁻².

Further preferably, when performing the boron diffusion doping treatment to the intrinsic amorphous silicon layer, BCl₃ or BBr₃ is used as a doping gas for the boron-doped amorphous silicon layer, the doping gas and oxygen are introduced at temperature of 800°C to 850°C, and the temperature is kept, so that the boron-doped amorphous silicon layer is obtained.

Preferably, in the step S2, the preparation method for the amorphous silicon layer is PVD method or PECVD method, and the amorphous silicon layer has a thickness of 50 to 200 nm.

Preferably, in the step S1, the silicon wafer is cleaned and textured by using a NaOH or KOH solution, and the reflectivity of the obtained pyramid-shaped textured surface is 10% to 12%.

Preferably, in the step S5, the silicon wafer is placed into a HF solution to remove the borosilicate glass layer on the front surface of the silicon wafer, and the polycrystalline silicon layer is removed by using a mixed acid solution of HF and HNO₃, an ammonia water solution, a tetramethyl ammonium hydroxide solution, a sodium hydroxide solution or a potassium hydroxide solution.

In the existing preparation method for boron-doped emitter (referred to as the existing method for short, e.g., CN114023635A), since the boron-doped amorphous silicon layer (or polycrystalline silicon layer) is not used as the sacrificial layer for the boron-doped emitter, the boron-doped emitter includes the boron-doped polycrystalline silicon layer formed by crystallizing the boron-doped amorphous silicon layer. However, both polycrystalline silicon and monocrystalline silicon are not silicon dioxide, and there is almost no difference in the solid solubility of boron in monocrystalline silicon or polycrystalline silicon. Thus, theoretically, there is basically no difference in the interfacial segregation coefficient for the diffusion of boron into the interface structure between the boron-doped polycrystalline silicon layer and the monocrystalline silicon wafer. Therefore, theoretically, unlike the boron-doped ECV of the boron-doped emitter obtained by the traditional preparation method, the distribution of the boron doping concentration on the boron-doped ECV curve of the existing boron-doped emitter: showing a distribution trend of first ascending and then descending.

However, after tests, the applicant has found that, in the boron-doped ECV curve of the boron-doped emitter obtained by the existing method, the boron doping concentration of the surface layer of the boron-doped emitter is not the maximum value of the boron doping concentration. In the preparation method of the present invention, the boron-doped amorphous silicon layer (or polycrystalline silicon layer) on the front surface of the silicon wafer is used as the doping source and sacrificial layer of the boron-doped emitter. In the step S5, after the polycrystalline silicon layer is removed so that the boron-doped emitter is exposed and located on the front surface of the silicon wafer, in the boron-doped ECV curve of the obtained boron-doped emitter, the maximum value of the boron doping concentration is located in the region within a depth of 50 nm from the front surface the boron-doped emitter. Since this region is relatively shallow from the front surface of the silicon wafer (or boron-doped emitter) treated in the step S5, this region is called the surface layer of the silicon wafer (or the surface layer of the boron-doped emitter). Therefore, in the boron-doped ECV curve of the boron-doped emitter of the present invention, the maximum value of the boron doping concentration is at the surface layer of the silicon wafer.

The applicant believes that the above difference between the boron-doped ECV curves of the boron-doped emitters obtained by the existing method and the method of the present invention is mainly due to the fact that: the boron doping amount in the polycrystalline silicon layer is relatively large because the boron-doped amorphous silicon layer (or polycrystalline silicon layer) is used as the doping source for the boron-doped emitter, so that the diffusion of boron in the boron-doped polycrystalline silicon layer can be regarded as infinite source diffusion and the diffusion distribution conforms to the complementary error function distribution). Therefore, in the boron-doped ECV curve of the boron-doped emitter obtained by the existing method, the boron doping concentration on the surface layer of the boron-doped emitter is not the maximum value of the boron doping concentration. However, in the preparation method for boron-doped emitter of the present invention, the boron-doped amorphous silicon layer is used as the doping source and sacrificial layer of the boron-doped emitter. After the polycrystalline silicon layer is removed, the diffusion distribution of boron from the surface of the silicon wafer (e.g., monocrystalline silicon wafer) to the inside of the silicon wafer can be regarded as a finite source diffusion distribution (i.e., a constant source diffusion distribution). Since the diffusion distribution of boron atoms in the boron-doped emitter of the present invention conforms to the Gaussian function distribution, the diffusion distribution of boron atoms from the surface to the inside of the boron-doped emitter of the present invention basically satisfies the trend of gradual decrease. That is, in the boron-doped ECV curve of the boron-doped emitter of the present invention, the maximum value of the boron doping concentration is at the surface layer of the silicon wafer.

Compared with the prior art, the present invention has at least the following beneficial effects.

In the preparation method for boron-doped emitter of the present invention, the boron-doped amorphous silicon layer on the front surface of the silicon wafer is used as the doping source and sacrificial layer of the boron-doped emitter. The crystallized polycrystalline silicon layer is removed after boron doping is completed, so the boron-doped ECV curve of the boron-doped emitter formed by the method of the present invention is distinct from the boron-doped ECV curve of the boron-doped emitter formed by a traditional preparation method. Therefore, the maximum value of the boron doping concentration is at the surface layer of the silicon wafer but not in the bulk of the silicon wafer, thereby greatly reducing auger recombination and SRH recombination of the bulk of the silicon wafer. Moreover, since the boron doping concentration on the surface layer of the silicon wafer is the maximum value of the boron doping concentration, the optimal sintering depth of the electrode metal slurry will be obviously reduced, so that the corrosion damage to the emitter region by the electrode metal slurry is less, the damage to the space charge region of the silicon wafer by heavy metal elements in the electrode metal slurry is also less, and the surface recombination of the boron-doped emitter can be reduced. Meanwhile, the electrode metal slurry can form good contact with the boron-doped emitter, thereby it is beneficial to reduce contact resistivity, leading to reduced metal recombination and resulting in lower matching difficulty of the electrode metal slurry.

In addition, in the existing method (e.g., CN114023635A), since the boron-doped amorphous silicon layer is not used as the sacrificial layer of the boron-doped emitter, the boron-doped emitter includes a boron-doped polycrystalline silicon layer formed by crystallizing the boron-doped amorphous silicon layer. After tests, it is found that, in the boron-doped ECV curve of the boron-doped emitter obtained by the existing method, the boron doping concentration on the surface layer of the silicon wafer is not the maximum value of the boron doping concentration, so the silicon wafer prepared by the existing method still has high bulk recombination, surface recombination and metal recombination. Moreover, since the existence of the boron-doped polycrystalline silicon layer on the front surface of the silicon wafer will lead to parasitic light absorption loss, thereby limiting the light absorption in the short light band (300-600 nm wave band), affecting the light utilization rate on the front surface and further leading to the short-circuit current loss of cells.

### BRIEF DESCRIPTION OF THE DRAWINGS

FIG. 1 is a sectional view of the silicon wafer in the preparation method for boron-doped emitter after step 1 in Embodiment 1;
FIG. 2 is a sectional view of the silicon wafer in the preparation method for boron-doped emitter after step 2 in Embodiments 1-3;
FIG. 3 is a sectional view of the silicon wafer in the preparation method for boron-doped emitter after step 3 in Embodiments 1-2;
FIG. 4 is a sectional view of the silicon wafer in the preparation method for boron-doped emitter after step 3 in Embodiment 3;
FIG. 5 is a sectional view of the silicon wafer in the preparation method for boron-doped emitter after step 4 in Embodiments 1-3;
FIG. 6 is a sectional view of the silicon wafer in the preparation method for boron-doped emitter after step 5 in Embodiments 1-3;
FIG. 7 is a comparison diagram of the boron-doped ECV curves of the boron-doped emitters in Embodiment 1, Comparative Embodiment 1 and the traditional preparation method;
FIG. 8 is a comparison diagram of the boron-doped ECV curves of the boron-doped emitters in Embodiment 2 and the traditional preparation method; and
FIG. 9 is a comparison diagram of the boron-doped ECV curves of the boron-doped emitters in Embodiment 3 and the traditional preparation method;

Description of the reference numbers: 1: silicon wafer; 2: amorphous silicon layer; 21: polycrystalline silicon layer; 3: boron-doped emitter; 4: borosilicate glass layer; and, 5: silicon dioxide layer.

### DETAILED DESCRIPTION OF THE PRESENT INVENTION

To make the objectives, features and advantages of the present invention more apparent and comprehensible, the present invention will be further described below in detail by specific embodiments with reference to the accompanying drawings.

### Embodiment 1

This embodiment provides a preparation method for a boron-doped emitter, including the following sequential steps.

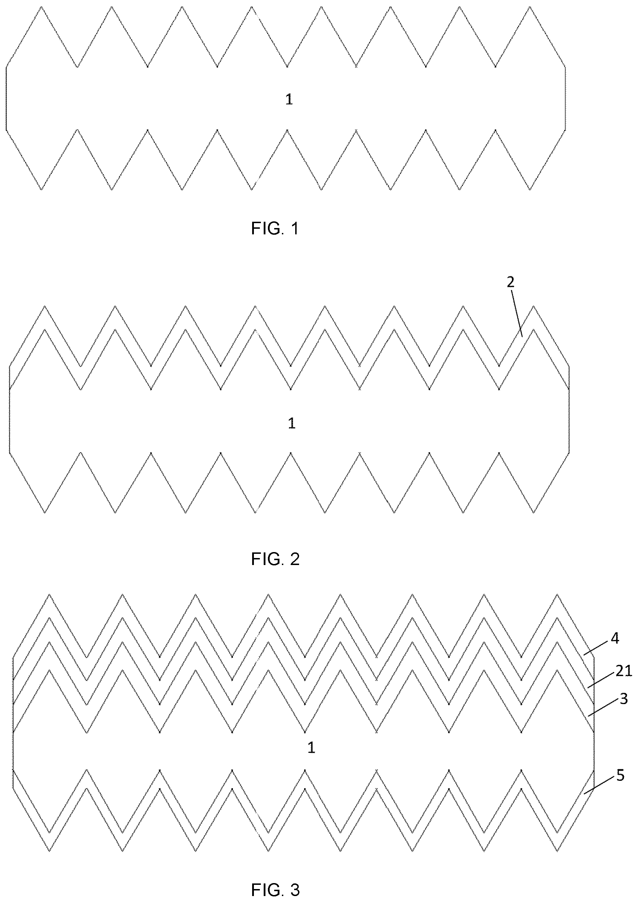

In step 1, an N-type monocrystalline silicon wafer 1 is selected as a substrate, the silicon wafer 1 is cleaned and textured to remove damaged layers on surfaces of the silicon wafer 1, and antireflective pyramid-shaped textured surfaces are formed on both front and back surfaces of the silicon wafer 1. The structure after the treatment in step 1 is shown in FIG. 1. The resistivity of the N-type monocrystalline silicon wafer 1 is 0.5 to 1.5 Ω/sq, and the reflectivity of the pyramid-shaped textured surfaces is controlled within the range of 10% to 12%.

Specifically, the silicon wafer 1 is cleaned and textured by using a NaOH solution, the concentration of NaOH is 1% to 2%, the treatment temperature is 78°C to 84°C, and the treatment time is 5 min to 10 min.

Of course, in other examples, it is also possible to clean and texture the silicon wafer 1 by using a KOH solution.

In step 2, an in-situ boron-doped amorphous silicon layer 2 is deposited on the textured surface of the front surface of the silicon wafer 1 treated in the step 1. The structure after the treatment in step 2 is shown in FIG. 2. The thickness of the amorphous silicon layer 2 deposited on the textured surface of the front surface of the silicon wafer 1 is controlled within 50 nm to 200 nm, preferably 100 nm to 200 nm.

Specifically, the in-situ boron-doped amorphous silicon layer 2 is deposited on the textured surface of the front surface of the silicon wafer 1 by PVD method. Specifically, an intrinsic silicon target is fixed in a magnetron sputtering reaction cavity, and the distance from the front surface of the silicon wafer 1 to the target is kept at 10 cm to 50 cm. Then, in an argon atmosphere, the reaction gas pressure is adjusted as 0.5 Pa to 1.0 Pa, boron fluoride gas is introduced, and the ratio of boron fluoride to argon is controlled to be 8% to 10%. The process temperature for deposition is 250°C to 300°C, and the reaction time for deposition is 3 min to 6 min.

Of course, in other examples, it is also possible to deposit the boron-doped amorphous silicon layer 2 on the textured surface of the front surface of the silicon wafer 1 by other methods such as PECVD method.

In addition, in this embodiment, since the method of depositing the in-situ boron-doped amorphous silicon layer 2 is adopted, it is unnecessary to carry out an additional ion implantation or diffusion doping procedure to add the boron doping source to the amorphous silicon layer 2, so that the preparation procedure in this embodiment is simpler.

In step 3, annealing treatment is carried out on the amorphous silicon layer 2 of the silicon wafer 1: in-situ boron-doped boron atoms of the amorphous silicon layer 2 are activated and diffused into the silicon wafer 1 at high temperature (e.g., 900°C to 1050°C), so thatboron-doped emitter 3 is formed on the front surface of the silicon wafer 1, and the amorphous silicon layer 2 is crystallized into a polycrystalline silicon layer 21 at this high temperature. This polycrystalline silicon layer 21 is located on the front surface of the boron-doped emitter 3. Then, oxygen is introduced in the cooling process, so that a borosilicate glass layer 4 with a thickness of 40 nm to 60 nm is formed on the front surface of the silicon wafer 1. This borosilicate glass layer 4 is located on the front surface of the polycrystalline silicon layer 21. The structure after the treatment in step 3 is shown in FIG. 3.

Specifically, the silicon wafer 1 deposited with the amorphous silicon layer 2 is placed into a quartz boat, the quartz boat is conveyed into a tubular furnace, nitrogen is introduced as an annealing atmosphere, and the temperature is raised to 960°C and then kept at 960°C for 1 h. At this time, boron-doped boron atoms of the amorphous silicon layer 2 are activated and diffused into the silicon wafer 1, so that a boron-doped emitter 3 is formed on the front surface of the silicon wafer 1, and the amorphous silicon layer 2 is crystallized into a polycrystalline silicon layer 21 at the high temperature. Then, cooling is performed, and oxygen is introduced in the cooling process, so that a relatively thick borosilicate glass layer 4 is formed on the front surface of the silicon wafer 1. At this time, the back surface of the silicon wafer 1 is also oxidized to form a silicon dioxide layer 5. So far, the annealing treatment to the silicon wafer 1 deposited with the amorphous silicon layer 2 is completed.

In step 3, the thickness of the borosilicate glass layer 4 on the front surface of the silicon wafer 1 is preferably controlled within a range of 40 nm to 60 nm. At this time, the borosilicate glass layer 4 on the front surface of the silicon wafer 1 is relatively thick and can well protect the front surface of the silicon wafer 1 in the polishing process in the subsequent step 4, thereby facilitating the accurate removal of the polycrystalline silicon layer 21 on the front surface of the silicon wafer 1 in the subsequent step 5 and further improving the quality of the obtained boron-doped emitter 3. This is because the boron-doped emitter 3 and the polycrystalline silicon layer 21 on the front surface of the silicon wafer 1 in the polishing process in the subsequent step 4 will be at risk of being etched if the borosilicate glass layer 4 on the front surface of the silicon wafer 4 is relatively thin, so that it is disadvantageous for the accurate removal of the polycrystalline silicon layer 21 on the front surface of the silicon wafer 1 in the subsequent step 5, thereby resulting in the damage to the boron-doped emitter 3, leading to high recombination and affecting the quality of the boron-doped emitter 3 on the front surface of the silicon wafer 1.

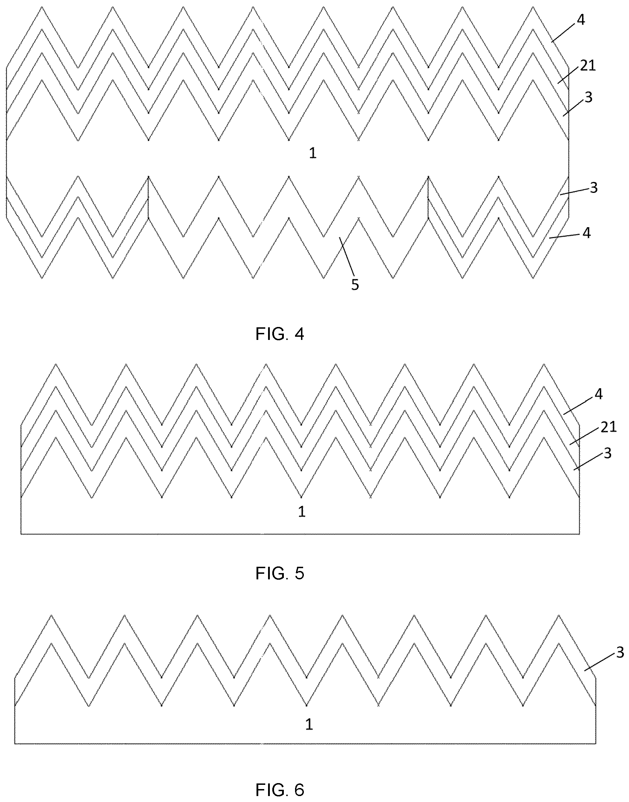

In step 4, the back surface of the silicon wafer 1 is placed on a HF solution, while the front surface of the silicon wafer 1 is not in contact with the HF solution, so that the silicon dioxide layer 5 on the back surface of the silicon wafer 5 is removed; and then, the silicon wafer 1 is placed into the heated alkali solution to polish the back surface of the silicon wafer 1, so that the back surface of the silicon wafer 1 forms a flat back surface morphological appearance. The structure after the treatment in step 4 is shown in FIG. 5.

Specifically, the back surface of the silicon wafer 1 is placed and floated on a HF solution with a concentration of 1% to 5% to remove the silicon dioxide layer 5 on the back surface of the silicon wafer 1; and then, the back surface of the silicon wafer 1 is immersed into a NaOH solution with a temperature of 60°C to 70°C and a concentration of 2% to 2.5% to polish the back surface of the silicon wafer 1, so that the back surface of the silicon wafer 1 forms a flat back surface morphological appearance.

In step 4, only the silicon dioxide layer 5 on the back surface of the silicon wafer 1 is removed, while the borosilicate glass layer 4 on the front surface of the silicon wafer 1 is reserved. Thus, the relatively thick borosilicate glass layer 4 on the front surface of the silicon wafer 1 can well protect the front surface of the silicon wafer 1 in the polishing process, thereby facilitating the accurate removal of the polycrystalline silicon layer 21 on the front surface of the silicon wafer 1 in the subsequent step 5 and further improving the quality of the obtained boron-doped emitter 3.

In step 5, the front surface of the silicon wafer 1 is placed into the HF solution to remove the borosilicate glass layer 4 on the front surface of the silicon wafer 1, the front surface of the silicon wafer 1 is then immersed into an acid or alkaline solution to remove the polycrystalline silicon layer 21 on the front surface of the silicon wafer 1, and the silicon wafer 1 is dried to obtain the silicon wafer 1 with the boron-doped emitter 3 on its front surface. The structure after the treatment in step 5 is shown in FIG. 6. The acid solution is a mixed solution of HF and HNO₃. The alkali solution is an ammonia water solution, a tetramethyl ammonium hydroxide solution, a sodium hydroxide solution or a potassium hydroxide solution.

Specifically, the front surface of the silicon wafer 1 is placed into a HF solution with a concentration of 1% to 5% to remove the borosilicate glass layer 4 on the front surface of the silicon wafer 1, and the front surface of the silicon wafer 1 is then immersed into a NaOH solution with a temperature of 30°C to 70°C and a concentration of 0.03% to 1.2%. It is preferable to add an auxiliary additive (e.g., the cleaning additive for winding plating Poly layer by the Tuobang Technologies) with a volume ratio of 1% to 10% into the NaOH solution, thereby stably controlling the etching speed of the polycrystalline silicon layer 21 on the front surface of the silicon wafer 1 by the NaOH solution and further removing the polycrystalline silicon layer 21 on the front surface of the silicon wafer 1.

In the preparation method for a boron-doped emitter of the present invention, the boron-doped amorphous silicon layer 2 on the front surface of the silicon wafer 1 is used as the doping source and sacrificial layer of the boron-doped emitter 3. Specifically, an amorphous silicon layer 2 is deposited on the front surface of the textured silicon wafer 1, and the boron-doped amorphous silicon layer 2 is used as boron doping for annealing (after annealing treatment, the amorphous silicon layer 2 is converted into a polycrystalline silicon layer 21). Then, after boron doping is completed, the crystallized polycrystalline silicon layer 21 is removed, so that the boron-doped emitter 3 is exposed and located on the front surface of the silicon wafer 1. At this time, the front surface of the boron-doped emitter 3 is the front surface of the silicon wafer 1, and the boron doping concentration of the front surface of the boron-doped emitter 3 is not less than 95% of the maximum value of the boron doping concentration of the boron-doped emitter 3. Referring to FIG. 6, in the present invention, the maximum value of the boron doping concentration of the boron-doped emitter 3 is at the surface layer of the silicon wafer 1 (i.e., the surface layer of the boron-doped emitter 3) treated in the steps 1-5 within a depth of 50 nm from the front surface of the boron-doped emitter 3.

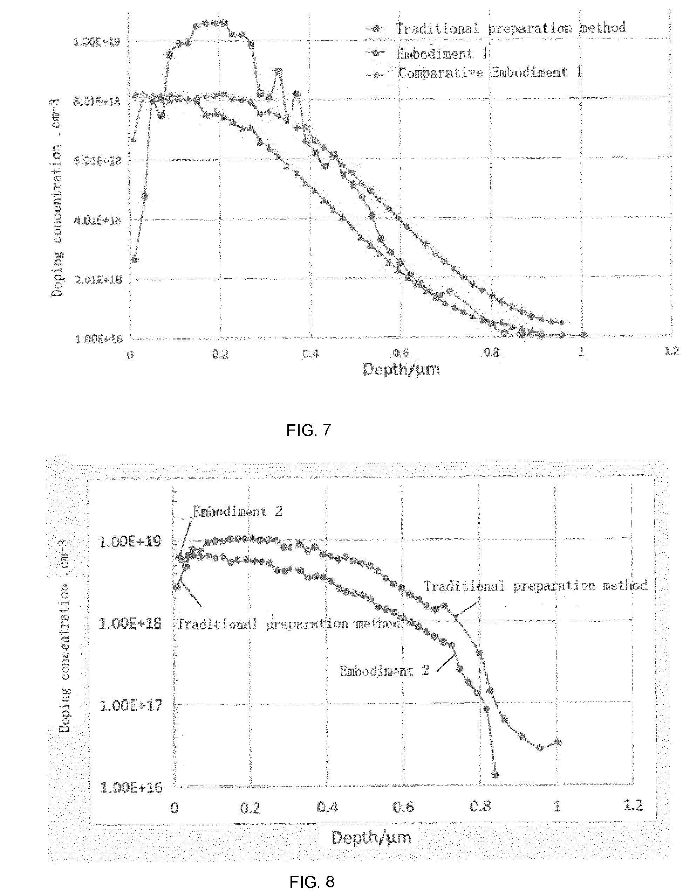

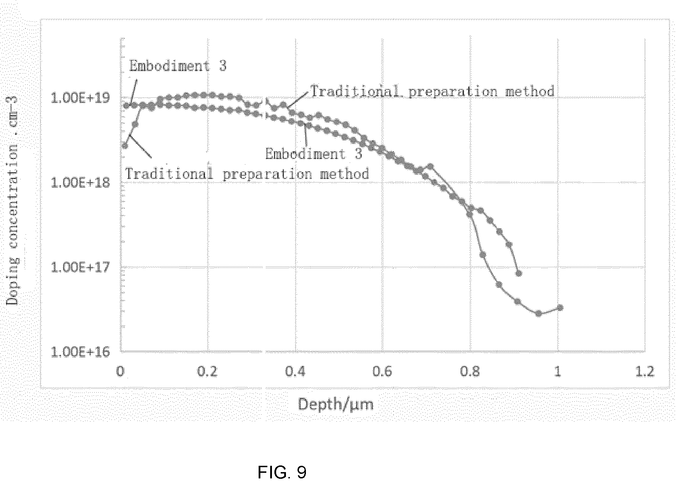

Thus, the boron-doped ECV curve of the boron-doped emitter formed by the preparation method of the present invention is distinct from the boron-doped ECV curve of the boron-doped emitter formed by the traditional preparation method (see FIGS. 7-9), so that the boron doping concentration of the surface layer of the silicon wafer 1 is the maximum value of the boron doping concentration, that is, the maximum value of the boron doping concentration is at the surface layer of the silicon wafer 1 but not in the bulk of the silicon wafer 1, thereby greatly reducing auger recombination and SRH recombination of the bulk of the silicon wafer 1.

Moreover, since the boron doping concentration of the surface layer of the silicon wafer 1 is the maximum value of the boron doping concentration, in the subsequent metallization process, the optimal sintering depth of the electrode metal slurry will be obviously reduced, so that the corrosion damage to the emitter region by the electrode metal slurry is less, heavy metal elements in the electrode metal slurry are distributed shallowly in the silicon wafer 1, the damage to the space charge region of the silicon wafer 1 by these heavy metal elements is also less, and the surface recombination of the boron-doped emitter 3 can be reduced. Meanwhile, even if the sintering depth of the electrode metal slurry is reduced, the good contact between the electrode metal slurry and the boron-doped emitter 3 can be ensured, thereby facilitating the reduction of the contact resistivity and leading to reduced metal recombination. Moreover, since the optimal sintering depth of the electrode metal slurry is shallower, the matching difficulty of the electrode metal slurry is lower.

In addition, in the existing preparation method for a boron-doped emitter (e.g., CN114023635A), only the boron-doped amorphous silicon layer is used as the doping source of the boron-doped emitter, but the boron-doped amorphous silicon layer is not used as the sacrificial layer of the boron-doped emitter, that is, the boron-doped emitter includes a boron-doped polycrystalline silicon layer formed by crystallizing the boron-doped amorphous silicon layer. After tests, it is found that in the boron-doped ECV curve of the boron-doped emitter of this existing method, the boron doping concentration of the surface layer of the silicon wafer is not the maximum value of the boron doping concentration. Therefore, this silicon wafer obtained by the existing method still has relatively high bulk recombination, surface recombination and metal recombination. Moreover, in the existing preparation method for a boron-doped emitter, since the existence of the boron-doped polycrystalline silicon layer on the front surface of the silicon wafer will lead to parasitic light absorption loss, thereby limiting the light absorption in the short light band (300-600 nm wave band), affecting the light utilization rate on the front surface and leading to the short-circuit current loss of cells. However, the preparation method for boron-doped emitter of the present invention will not lead to such loss.

### Embodiment 2

This embodiment provides a preparation method for a boron-doped emitter. Specifically referring to Embodiment 1, this embodiment differs from Embodiment 1 in that:

In step 2, an intrinsic amorphous silicon layer 2 is deposited on the textured surface of the front surface of the silicon wafer 1 by PVD method. The structure after the treatment in the step 2 of this embodiment is shown in FIG. 2. Specifically, an intrinsic silicon target is fixed in a magnetron sputtering reaction cavity, and the distance from the front surface of the silicon wafer 1 to the target is kept at 10 cm to 50 cm; and then, in an argon atmosphere, the reaction gas pressure is adjusted as 0.5 Pa to 1.0 Pa, the process temperature for deposition is 250°C to 300°C, and the reaction time for deposition is 3 min to 6 min, so that the intrinsic amorphous silicon layer 2 is deposited on the textured surface of the front surface of the silicon wafer 1.

In step 3, before annealing treatment, ion implantation is carried out on the front surface of the silicon wafer 1 deposited with the intrinsic amorphous silicon layer 2 in advance to obtain a boron-doped amorphous silicon layer 2. The process parameters for ion implantation include: the doping source used for preparing the boron-doped amorphous silicon layer 2 is BF₂, and the doping dose is 1-10E15.cm⁻². The structure after the treatment in the step 3 of this embodiment is shown in FIG. 3.

Specifically, the process parameters for ion implantation are as follows: the doping dose of BF₂ is 8E15.cm⁻², and the voltage for ion implantation is 2keV.

### Embodiment 3

This embodiment provides a preparation method for boron-doped emitter. Specifically referring to Embodiment 2, this embodiment differs from Embodiment 2 in that:
In step 3, before annealing treatment, boron diffusion doping is carried out on the front surface of the silicon wafer 1 deposited with the intrinsic amorphous silicon layer 2 in advance to obtain a boron-doped amorphous silicon layer 2. The process parameters for boron diffusion doping include: BCl₃ or BBr₃ is used as doping gas for preparing the boron-doped amorphous silicon layer 2, the doping gas and oxygen are introduced at temperature of 800°C to 850°C, and the temperature is kept, so that the boron-doped amorphous silicon layer 2 is obtained.

Specifically, the specific operation of the step 3 is as follows: the silicon wafer 1 deposited with the amorphous silicon layer 2 is placed into a quartz boat, the quartz boat is conveyed into a tubular furnace, nitrogen is introduced as an atmosphere in the tube, and the temperature is raised to 820°C, and 400sccm of BCl₃ and 600sccm of oxygen are introduced and then kept at 800°C for 800s. in this way, the boron-doped amorphous silicon layer 2 is obtained by this boron diffusion doping method. Then, the source introducing is stopped, and annealing treatment is carried out on the silicon wafer 1 with reference to the step 3 in Embodiment 3. In this embodiment, in the process of obtaining the boron-doped amorphous silicon layer 2 by the boron diffusion doping method above, the edge of the back surface of the silicon wafer 1 will be winding plated. As a result, after annealing treatment, the boron-doped emitter 3 and the borosilicate glass layer 4 will be sequentially formed at the edge of the back surface of the silicon wafer 1, and the middle part of the back surface of the silicon wafer 1 will still be oxidized to form a silicon dioxide layer 5. The structure after the treatment in the step 3 of this embodiment is shown in FIG. 4.

### Comparative Embodiment 1

This comparative embodiment provides a preparation method for boron-doped emitter. Specifically referring to Embodiment 1, this comparative embodiment differs from Embodiment 1 in that:
In step 5, after the front surface of the silicon wafer is placed into the HF solution to remove the borosilicate glass layer on the front surface of the silicon wafer, the related operation of removing the polycrystalline silicon layer on the front surface of the silicon wafer is omitted, and the silicon wafer is dried, so that the silicon wafer with the boron-doped emitter on its front surface in this comparative embodiment is obtained. Since this comparative embodiment is similar to the prior art, the boron-doped amorphous silicon layer is not used as the sacrificial layer, so that the boron-doped emitter in this comparative embodiment includes the boron-doped polycrystalline silicon layer formed by crystallizing the boron-doped amorphous silicon layer.

### Performance test

1. The boron-doped ECV curves from the surface layers of the silicon wafers (i.e., the surface layers of the boron-doped emitters) to a certain depth inside the silicon wafers tested and obtained by the ECV tester of the WEP Company in Germany of the silicon wafers (since the borosilicate glass layer needs to be removed in the cell manufacturing process, the tested boron-doped emitter does not include the borosilicate glass layer, and the surface of the silicon wafer with the boron-doped emitter does not include the borosilicate glass layer) obtained in Embodiments 1-3, Comparative Embodiment 1 and the traditional method (referred to as the traditional preparation method for short) for preparing a boron-doped emitter . The obtained boron-doped ECV curves are shown in FIGS. 7-9. In FIGS. 7-9, the depth of the boron-doped ECV curves in Embodiments 1-3 and the traditional preparation method is from the front surface of the boron-doped emitter to the bulk of the silicon wafer. The depth of the boron-doped ECV curve in Comparative Embodiment 1 is from the front surface of the boron-doped polycrystalline silicon layer to the bulk of the silicon wafer.
   It can be seen from FIGS. 7-9 that the boron-doped ECV curves formed by the preparation methods for boron-doped emitter in Embodiments 1-3 of the present invention are distinct from the boron-doped ECV curve of the traditional preparation method (see FIGS. 7-9). Obviously, the boron doping concentration of the surface layers of the silicon wafers (i.e., the surface layers of the boron-doped emitters) obtained by the preparation methods for boron-doped emitter in Embodiments 1-3 of the present invention is the maximum value of the boron doping concentration.
2. Square resistance and auger recombination tests are carried on the emitter regions of the silicon wafers obtained in Embodiment 1, Comparative Embodiment 1 and the traditional preparation method. The silicon wafers obtained in Embodiment 1, Comparative Embodiment 1 and the traditional preparation method are manufactured into photovoltaic cells, respectively, and the metal combination, contact resistance and short-circuit current of the photovoltaic cells are tested. The above test results are shown in Table 1 below.

**Table 1**

| | Square resistance (Ω/sq) | Auger recombination (fA.cm²) | Metal recombination (fA.cm²) | Contact resistance (mΩ.cm²) | Short-circuit current (mA.cm²) |
|---|---|---|---|---|---|
| Traditional preparation method | 130 | 6.0 | 600 | 1.7 | 41.1 |
| Comparative Embodiment 1 | 145 | 4.4 | 450 | 1.4 | 39.7 |
| Embodiment 1 | 162 | 2.0 | 450 | 1.2 | 41.3 |

Although the preferred embodiments among the embodiments of the present invention have been described, those skilled in the art can make additional alterations and modifications to these embodiments once the basic creative concepts have been learnt. Therefore, the appended claims are interpreted as including the preferred embodiments and all alterations and modifications within the scope of the embodiments of the present invention.

Although the technical solutions provided by the present invention have been described above in detail and the principle and implementation of the present invention have been illustrated herein by specific examples, the foregoing description of the embodiments is merely for facilitating the understanding of the method of the present invention and the core concept thereof. Moreover, a person of ordinary skill in the art can make alterations to the specific implementations and the range of application according to the concept of the present invention. In conclusion, the contents in the specification shall not be regarded as limitations to the present invention.

## Claims

1. A preparation method for boron-doped emitter, wherein, comprising the following steps:
S1: cleaning and texturing an n-type silicon wafer (1) to remove damaged layers on surfaces of the silicon wafer (1) and form pyramid-shaped textured surfaces on the front and back surfaces of the silicon wafer (1);
S2: preparing a boron-doped amorphous silicon layer (2) on the textured surface of the front surface of the silicon wafer (1);
S3: carrying out annealing treatment to the boron-doped amorphous silicon layer (2), diffusing boron atoms of the boron-doped amorphous silicon layer (2) inward to the silicon wafer (1) to form boron-doped emitter (3) on the front surface of the silicon wafer (1), the amorphous silicon layer (2) is crystallized and transformed into a polycrystalline silicon layer (21) on the front surface of the boron-doped emitter (3), and introducing oxygen in the cooling process, so that a borosilicate glass layer (4) is formed on the front surface of the polycrystalline silicon layer (21), and a silicon dioxide layer (5) is formed on the back surface of the silicon wafer (1);
S4: removing the silicon dioxide layer (5), and polishing the back surface of the silicon wafer (1) to form flat morphological appearance on the back surface of the silicon wafer (1); and
S5: removing the borosilicate glass layer (4) and the polycrystalline silicon layer (21) in sequence, so that the boron-doped emitter (3) is exposed and located on the front surface of the silicon wafer (1), the boron doping concentration of the front surface of the boron-doped emitter (3) being not less than 95% of the maximum value of the boron doping concentration of the boron-doped emitter (3).

2. The preparation method for boron-doped emitter according to claim 1, wherein, in the step S5, the maximum value of the boron doping concentration is at a surface layer of the silicon wafer (1) within a depth of 50 nm from the front surface of the boron-doped emitter (3).

3. The preparation method for boron-doped emitter according to claim 1, wherein, in the step S3, the annealing treatment process is: sequentially forming the boron-doped emitter (3) and the polycrystalline silicon layer (21) on the front surface of the silicon wafer (1) at high temperature of 900°C to 1050°C, then cooling, and introducing oxygen in the cooling process, so that the borosilicate glass layer (4) with a thickness of 40 to 60 nm is formed on the front surface of the polycrystalline silicon layer (21).

4. The preparation method for boron-doped emitter according to claim 1 or 3, wherein, in the step S4, single-sided HF cleaning is carried out on the back surface of the silicon wafer (1) to remove the silicon dioxide layer (5) and reserve the borosilicate glass layer (4) on the front surface of the silicon wafer (1), and the back surface of the silicon wafer (1) is polished with an alkali solution to form flat morphological appearance on the back surface of the silicon wafer (1).

5. The preparation method for boron-doped emitter according to claim 1, wherein, the step S2 is: preparing an in-situ boron-doped amorphous silicon layer (2) on the textured surface of the front surface of the silicon wafer (1).

6. The preparation method for boron-doped emitter according to claim 1, wherein, the step S2 is: preparing an intrinsic amorphous silicon layer (2) on the textured surface of the front surface of the silicon wafer (1), and performing ion implantation or boron diffusion doping treatment on the intrinsic amorphous silicon layer (2) to obtain a boron-doped amorphous silicon layer (2).

7. The preparation method for boron-doped emitter according to claim 6, wherein, when performing the ion implantation treatment to the intrinsic amorphous silicon layer (2), BF₂ is used as a doping source for the boron-doped amorphous silicon layer (2), and the doping dose of BF₂ is 1-10E15.cm⁻².

8. The preparation method for boron-doped emitter according to claim 6, wherein, when performing the boron diffusion doping treatment to the intrinsic amorphous silicon layer (2), BCl₃ or BBr₃ is used as a doping gas for the boron-doped amorphous silicon layer (2,) the doping gas and oxygen are introduced at temperature of 800°C to 850°C, and the temperature is kept, so that the boron-doped amorphous silicon layer (2) is obtained.

9. The preparation method for boron-doped emitter according to claim 1, wherein, in the step S2, the preparation method for the amorphous silicon layer (2) is PVD method or PECVD method, and the amorphous silicon layer (2) has a thickness of 50 to 200 nm.

10. The preparation method for boron-doped emitter according to claim 1, wherein, in the step S1, the silicon wafer 1 is cleaned and textured by using a NaOH or KOH solution, and the reflectivity of the obtained pyramid-shaped textured surface is 10% to 12%.

11. The preparation method for boron-doped emitter according to claim 1, wherein, in the step S5, the silicon wafer (1) is placed into a HF solution to remove the borosilicate glass layer (4) on the front surface of the silicon wafer (1), and the polycrystalline silicon layer (21) is removed by using a mixed acid solution of HF and HNO₃, an ammonia water solution, a tetramethyl ammonium hydroxide solution, a sodium hydroxide solution or a potassium hydroxide solution.

## Patentansprüche

1. Herstellungsverfahren für einen bordotierten Emitter, umfassend die folgenden Schritte:
S1: Reinigen und Strukturieren eines n-Typ-Siliziumwafers (1), um beschädigte Schichten auf Oberflächen des Siliziumwafers (1) zu entfernen und pyramidenförmige strukturierte Oberflächen auf der vorderen und der hinteren Oberfläche des Siliziumwafers (1) zu bilden;
S2: Herstellen einer bordotierten amorphen Siliziumschicht (2) auf der strukturierten Oberfläche der vorderen Oberfläche des Siliziumwafers (1);
S3: Durchführen einer Glühbehandlung an der bordotierten amorphen Siliziumschicht (2), Diffundieren von Boratomen der bordotierten amorphen Siliziumschicht (2) nach innen in den Siliziumwafer (1), um einen bordotierten Emitter (3) auf der vorderen Oberfläche des Siliziumwafers (1) zu bilden, wobei die amorphe Siliziumschicht (2) kristallisiert wird und in eine polykristalline Siliziumschicht (21) auf der vorderen Oberfläche des bordotierten Emitters (3) umgewandelt wird, und Einbringen von Sauerstoff in den Abkühlungsprozess, so dass sich auf der vorderen Oberfläche der polykristallinen Siliziumschicht (21) eine Borosilikatglasschicht (4) bildet, und sich auf der hinteren Oberfläche des Siliziumwafers (1) eine Siliziumdioxidschicht (5) bildet;
S4: Entfernen der Siliziumdioxidschicht (5), und Polieren der hinteren Oberfläche des Siliziumwafers (1), um ein flaches morphologisches Erscheinungsbild auf der hinteren Oberfläche des Siliziumwafers (1) zu bilden; und
S5: Entfernen der Borosilikatglasschicht (4) und der polykristallinen Siliziumschicht (21) nacheinander, so dass der bordotierte Emitter (3) freigelegt wird und sich auf der vorderen Oberfläche des Siliziumwafers (1) befindet, wobei die Bordotierungskonzentration der vorderen Oberfläche des bordotierten Emitters (3) nicht weniger als 95 % des Maximalwerts der Bordotierungskonzentration des bordotierten Emitters (3) beträgt.

2. Herstellungsverfahren für einen bordotierten Emitter nach Anspruch 1, wobei in Schritt S5 der Maximalwert der Bordotierungskonzentration in einer Oberflächenschicht des Siliziumwafers (1) innerhalb einer Tiefe von 50 nm von der vorderen Oberfläche des bordotierten Emitters (3) liegt.

3. Herstellungsverfahren für einen bordotierten Emitter nach Anspruch 1, wobei in Schritt S3 der Glühbehandlungsprozess lautet: sequenzielles Bilden des bordotierten Emitters (3) und der polykristallinen Siliziumschicht (21) auf der vorderen Oberfläche des Siliziumwafers (1) bei einer hohen Temperatur von 900 °C bis 1050 °C, anschließendes Abkühlen und Einbringen von Sauerstoff in den Abkühlungsprozess, so dass die Borosilikatglasschicht (4) mit einer Dicke von 40 bis 60 nm auf der vorderen Oberfläche der polykristallinen Siliziumschicht (21) gebildet wird.

4. Herstellungsverfahren für einen bordotierten Emitter nach Anspruch 1 oder 3, wobei in Schritt S4 eine einseitige HF-Reinigung auf der hinteren Oberfläche des Siliziumwafers (1) durchgeführt wird, um die Siliziumdioxidschicht (5) zu entfernen und die Borosilikatglasschicht (4) auf der vorderen Oberfläche des Siliziumwafers (1) zurückzuhalten, und die hintere Oberfläche des Siliziumwafers (1) mit einer Alkalilösung poliert wird, um ein flaches morphologisches Erscheinungsbild auf der hinteren Oberfläche des Siliziumwafers zu bilden (1).

5. Herstellungsverfahren für einen bordotierten Emitter nach Anspruch 1, wobei der Schritt S2 lautet: Herstellen einer in situ bordotierten amorphen Siliziumschicht (2) auf der strukturierten Oberfläche der vorderen Oberfläche des Siliziumwafers (1).

6. Herstellungsverfahren für einen bordotierten Emitter nach Anspruch 1, wobei der Schritt S2 lautet: Herstellen einer intrinsischen amorphen Siliziumschicht (2) auf der strukturierten Oberfläche der vorderen Oberfläche des Siliziumwafers (1), und Durchführen einer Ionenimplantation oder einer Bor-Diffusionsdotierungsbehandlung auf der intrinsischen amorphen Siliziumschicht (2), um eine bordotierte amorphe Siliziumschicht (2) zu erhalten.

7. Herstellungsverfahren für einen bordotierten Emitter nach Anspruch 6, wobei beim Durchführen der lonenimplantationsbehandlung an der intrinsischen amorphen Siliziumschicht (2) BF₂ als eine Dotierungsquelle für die bordotierte amorphe Siliziumschicht (2) verwendet wird, und die Dotierungsdosis von BF₂ 1-10E15.cm⁻² beträgt.

8. Herstellungsverfahren für einen bordotierten Emitter nach Anspruch 6, wobei beim Durchführen der Bor-Diffusionsdotierungsbehandlung an der intrinsischen amorphen Siliziumschicht (2) BCl₃ oder BBr₃ als ein Dotierungsgas für die bordotierte amorphe Siliziumschicht (2) verwendet wird, das Dotierungsgas und Sauerstoff bei einer Temperatur von 800 °C bis 850 °C eingebracht werden, und die Temperatur so gehalten wird, dass die bordotierte amorphe Siliziumschicht (2) erhalten wird.

9. Herstellungsverfahren für einen bordotierten Emitter nach Anspruch 1, wobei in Schritt S2 das Herstellungsverfahren für die amorphe Siliziumschicht (2) ein PVD-Verfahren oder ein PECVD-Verfahren ist, und die amorphe Siliziumschicht (2) eine Dicke von 50 bis 200 nm aufweist.

10. Herstellungsverfahren für einen bordotierten Emitter nach Anspruch 1, wobei in Schritt S1 der Siliziumwafer 1 unter Verwendung einer NaOH- oder KOH-Lösung gereinigt und strukturiert wird, und die Reflektivität der erhaltenen pyramidenförmigen strukturierten Oberfläche 10 % bis 12 % beträgt.

11. Herstellungsverfahren für einen bordotierten Emitter nach Anspruch 1, wobei in Schritt S5 der Siliziumwafer (1) in eine HF-Lösung gegeben wird, um die Borosilikatglasschicht (4) auf der vorderen Oberfläche des Siliziumwafers (1) zu entfernen, und die polykristalline Siliziumschicht (21) unter Verwendung einer gemischten Säurelösung aus HF und HNO₃, einer Ammoniakwasserlösung, einer Tetramethylammoniumhydroxidlösung, einer Natriumhydroxidlösung oder einer Kaliumhydroxidlösung entfernt wird.

## Revendications

1. Procédé de préparation d'émetteur dopé au bore, dans lequel, comprenant les étapes suivantes :
S1 : le nettoyage et la texturation d'une tranche de silicium (1) de type n pour éliminer des couches endommagées sur des surfaces de la tranche de silicium (1) et former des surfaces texturées en forme de pyramide sur les surfaces avant et arrière de la tranche de silicium (1) ;
S2 : la préparation d'une couche (2) de silicium amorphe dopée au bore sur la surface texturée de la surface avant de la tranche de silicium (1) ;
S3 : la mise en œuvre d'un traitement de recuit sur la couche (2) de silicium amorphe dopée au bore,
la diffusion d'atomes de bore de la couche (2) de silicium amorphe dopée au bore vers l'intérieur de la tranche de silicium (1) pour former un émetteur (3) dopé au bore sur la surface avant de la tranche de silicium (1), la couche (2) de silicium amorphe est cristallisée et transformée en une couche (21) de silicium polycristallin sur la surface avant de l'émetteur (3) dopé au bore, et l'introduction d'oxygène dans le processus de refroidissement, de sorte qu'une couche (4) de verre borosilicaté soit formée sur la surface avant de la couche (21) de silicium polycristallin, et qu'une couche (5) de dioxyde de silicium soit formée sur la surface arrière de la tranche de silicium (1) ;
S4 : l'élimination de la couche (5) de dioxyde de silicium, et le polissage de la surface arrière de la tranche de silicium (1) pour former un aspect morphologique plat sur la surface arrière de la tranche de silicium (1) ; et
S5 : l'élimination de la couche (4) de verre borosilicaté et de la couche (21) de silicium polycristallin dans l'ordre, de sorte que l'émetteur (3) dopé au bore soit exposé et situé sur la surface avant de la tranche de silicium (1), la concentration de dopage au bore de la surface avant de l'émetteur (3) dopé au bore n'étant pas inférieure à 95 % de la valeur maximale de la concentration de dopage au bore de l'émetteur (3) dopé au bore.

2. Procédé de préparation d'émetteur dopé au bore selon la revendication 1, dans lequel, à l'étape S5, la valeur maximale de la concentration de dopage au bore est au niveau d'une couche de surface de la tranche de silicium (1) dans une profondeur de 50 nm à partir de la surface avant de l'émetteur (3) dopé au bore.

3. Procédé de préparation d'émetteur dopé au bore selon la revendication 1, dans lequel, à l'étape S3, le procédé de traitement de recuit est : le formage séquentiel de l'émetteur (3) dopé au bore et de la couche (21) de silicium polycristallin sur la surface avant de la tranche de silicium (1) à une température élevée de 900 °C à 1 050 °C, puis le refroidissement, et l'introduction d'oxygène dans le processus de refroidissement, de sorte que la couche (4) de verre borosilicaté d'une épaisseur de 40 à 60 nm est formée sur la surface avant de la couche (21) de silicium polycristallin.

4. Procédé de préparation d'émetteur dopé au bore selon la revendication 1 ou la revendication 3, dans lequel, à l'étape S4, un nettoyage HF unilatéral est mis en œuvre sur la surface arrière de la tranche de silicium (1) pour éliminer la couche (5) de dioxyde de silicium et réserver la couche (4) de verre borosilicaté sur la surface avant de la tranche de silicium (1), et la surface arrière de la tranche de silicium (1) est polie avec une solution alcaline pour former un aspect morphologique plat sur la surface arrière de la tranche de silicium (1).

5. Procédé de préparation d'émetteur dopé au bore selon la revendication 1, dans lequel, l'étape S2 est : la préparation d'une couche (2) de silicium amorphe dopée au bore in situ sur la surface texturée de la surface avant de la tranche de silicium (1).

6. Procédé de préparation d'émetteur dopé au bore selon la revendication 1, dans lequel, l'étape S2 est : la préparation d'une couche (2) de silicium amorphe intrinsèque sur la surface texturée de la surface avant de la tranche de silicium (1), et la réalisation d'une implantation ionique ou d'un traitement de dopage par diffusion de bore sur la couche (2) de silicium amorphe intrinsèque pour obtenir une couche (2) de silicium amorphe dopée au bore.

7. Procédé de préparation d'émetteur dopé au bore selon la revendication 6, dans lequel, lors de la réalisation du traitement d'implantation ionique sur la couche (2) de silicium amorphe intrinsèque, BF₂ est utilisé comme source de dopage pour la couche (2) de silicium amorphe dopée au bore, et la dose de dopage de BF₂ est de 1-10E15 cm⁻².

8. Procédé de préparation d'émetteur dopé au bore selon la revendication 6, dans lequel, lors de la réalisation du traitement de dopage par diffusion de bore sur la couche (2) de silicium amorphe intrinsèque, BCl₃ ou BBr₃ est utilisé comme gaz dopant pour la couche (2) de silicium amorphe dopée au bore, le gaz dopant et l'oxygène sont introduits à une température de 800 °C à 850 °C, et la température est maintenue, de sorte que la couche (2) de silicium amorphe dopée au bore soit obtenue.

9. Procédé de préparation d'émetteur dopé au bore selon la revendication 1, dans lequel, à l'étape S2, le procédé de préparation de la couche (2) de silicium amorphe est le procédé PVD ou le procédé PECVD, et la couche (2) de silicium amorphe présente une épaisseur de 50 à 200 nm.

10. Procédé de préparation d'émetteur dopé au bore selon la revendication 1, dans lequel, à l'étape S1, la tranche de silicium 1 est nettoyée et texturée en utilisant une solution de NaOH ou de KOH, et la réflectivité de la surface texturée en forme de pyramide obtenue est de 10 % à 12 %.

11. Procédé de préparation d'émetteur dopé au bore selon la revendication 1, dans lequel, à l'étape S5, la tranche de silicium (1) est placée dans une solution **HF** pour éliminer la couche (4) de verre borosilicaté sur la surface avant de la tranche de silicium (1), et la couche (21) de silicium polycristallin est éliminée en utilisant une solution acide mélangée de HF et de HNO₃, une solution d'eau ammoniacale, une solution d'hydroxyde de tétraméthylammonium, une solution d'hydroxyde de sodium ou une solution d'hydroxyde de potassium.
